# FASCICULE DE BREVET EUROPEEN

(11) **EP 0 678 868 B1**
(45) Date de publication et mention de la délivrance du brevet: **18.06.1997**
(21) Numéro de dépôt: 95470013.4
(22) Date de dépôt: 14.04.1995
(51) Int. Cl.: G11C 5/14, H02M 3/07

(54) **Circuit multiplicateur de tension**
Spannungsvervielfacherschaltung
Voltage multiplying circuit

(30) Priorité: 21.04.1994 FR 9404985
(43) Date de publication de la demande: 25.10.1995
(73) Titulaire: SGS-THOMSON MICROELECTRONICS S.A., 94250 Gentilly (FR)
(72) Inventeur: Drouot, Sylvie, F-57000 Metz (FR)
(74) Mandataire: Schmit, Christian Norbert Marie

(56) Documents cités:
- GB-A- 2 261 307
- IEEE JOURNAL OF SOLID-STATE CIRCUITS., vol. 18, no. 5, Octobre 1983 NEW YORK US, pages 452-456, NAKANO ET AL 'A SUB-100NS 256K DRAM WITH OPEN BIT LINE SCHEME'
- IEEE INTERNATIONAL SOLID STATE CIRCUITS CONFERENCE., vol. 34, Février 1991 NEW YORK US, pages 268-269, SATO TE AL 'A 4MB PSEUDO SRAM OPERATING AT 2.6 +/-1V WITH 3MUAMPERE DATA RETENTION CURRENT'

## Description

L'invention concerne un circuit multiplicateur de tension, fonctionnant sous de faibles tensions d'alimentation. Un tel circuit permet de produire une tension de sortie, à partir d'une tension d'alimentation reçue, en chargeant et déchargeant un ou plusieurs condensateurs consécutivement, de telle façon que la tension de sortie soit supérieure à la tension d'alimentation. Ce circuit, appelé également pompe de charge, trouve principalement son application dans l'alimentation de circuits capacitifs.

On utilise par exemple des multiplicateurs de tension dans le domaine des mémoires non volatiles organisées matriciellement en lignes et en colonnes, et comportant des cellules de mémorisation réalisées à partir de transistors de type MOS, placées aux intersections des lignes et des colonnes. On utilise des multiplicateurs de tension pour produire des tensions de polarisation appliquées aux grilles de commande de ces transistors. En effet, on peut modéliser l'ensemble des grilles de commande de ces transistors par une capacité équivalente, ceux-ci étant commandés en tension et non en courant. Pour une mémoire morte comportant plusieurs milliers de lignes et de colonnes, on atteint couramment une capacité équivalente d'une à plusieurs centaines de picofarads.

Dans l'état de la technique, on connaît des circuits multiplicateurs de tension, dits de Schenkel. Ce type de circuit comporte un ou plusieurs étages montés en série. Chaque étage comporte une entrée et un condensateur dont une première borne est connectée à l'entrée. Cette borne reçoit un signal d'horloge. L'autre borne de ce condensateur est connectée à une sortie par le biais d'une diode d'isolation.

Typiquement, le signal d'horloge oscille entre un potentiel de référence reçue sur une première borne d'entrée et un potentiel d'alimentation reçue sur une seconde borne d'entrée (en pratique, une masse et une tension positive VCC, de l'ordre de 5 volts par exemple).

Le condensateur du premier étage a sa deuxième borne connectée à la deuxième borne d'entrée par le biais d'une autre diode. Ainsi, quand l'horloge du premier étage est au potentiel de masse, le condensateur est chargé au potentiel de cette borne d'entrée, diminuée des pertes dues à l'effet de seuil et à l'effet substrat dans la diode (réalisée pratiquement avec un transistor MOS dont la grille de commande est reliée à la source). Puis, quand le signal d'horloge est au potentiel VCC, la tension aux bornes du condensateur monte à 2 * VCC - Vt en appelant Vt la tension de seuil du transistor monté en diode, et ce condensateur charge alors le condensateur de l'étage suivant, dont on a pris soin de mettre le signal d'horloge au potentiel de masse. Quand le potentiel du signal d'horloge passe au potentiel VCC, la tension aux bornes du condensateur du second étage monte alors à 3 * VCC - 2 * Vt (diode de transfert) etc. Ainsi, à chaque étage, la tension aux bornes du condensateur augmente d'une fois VCC - Vt. Le dernier étage fournit sur sa sortie, la tension de sortie. Cette sortie est un noeud capacitif et on peut modéliser le circuit à alimenter par un condensateur connecté entre cette sortie et la masse. Par transfert de charge, le potentiel de sortie va progressivement augmenter, par paliers de plus en plus petits, pour atteindre le potentiel (n + 1) * (VCC - Vt), avec n un nombre entier, en considérant n étages montés en série. Cette augmentation sera plus ou moins rapide suivant les valeurs des capacités des condensateurs et du gain de transfert en résultant.

Ce type de circuit a deux inconvénients :
- d'une part, du fait des pertes dues aux diodes d'isolation montées entre les étages, la valeur de la tension de sortie est limitée (à (n + 1) * [VCC - Vt]). Comme on souhaite, pour limiter la consommation des circuits intégrés, développer des circuits alimentés avec des tensions d'alimentation plus faibles (par exemple 3 volts), cette limitation est préjudiciable. En effet, la tension de seuil d'une diode vaut typiquement 1.2 à 1.5 volts, d'où une limitation équivalente à la moitié de la valeur de la tension d'alimentation, dans le pire des cas, entre un étage et l'étage suivant.
- d'autre part, ces pertes limitent le nombre de charges transférées entre chaque étage, d'où une augmentation du temps de montée de la tension de sortie.

Par exemple, si on souhaite doubler la tension d'alimentation et passer ainsi de 3 volts à 6 volts, théoriquement un seul étage suffit. En pratique, la tension de sortie est alors limitée entre 4.5 et 5 volts. Il faut donc rajouter au moins un étage supplémentaire, ce qui est pénalisant au niveau de l'encombrement. Il faut compter par ailleurs, sur l'encombrement supplémentaire du à la présence de circuits de contrôle pour produire le signal d'horloge des étages supplémentaires et pour coordonner les signaux d'horloge entre eux.

On pourrait envisager de réaliser les diodes à l'aide de transistors dits natifs, c'est-à-dire non implantés. Ces transistors présentent une faible tension de seuil, de l'ordre de 0.2 à 0.4 volts. Cette solution nécessiterait cependant de procéder à la qualification de ce type de technologie, ce qui est particulièrement long et coûteux.

La demande de brevet GB-A-2 261 307 et également IEEE JOURNAL OF SOLID-STATE CIRCUITS, vol. 18, n° 5, Oct. 1983, New York, USA, pages 452-456, NAKANO et al. sont deux documents qui présentent différentes solutions utilisant des transistors MOS afin de minimiser la chute de tension due à l'emploi de diodes sans réduire totalement cette chute de tension.

Dans IEEE JOURNAL of SOLID STATE CIRCUITS, vol 26, n°4, avril 1991, pages 465-472, NAKAKOME et al., "An experimental 1.5-v 64 Mbit DRAM", il est présenté un doubleur de tension dont la chute de tension en sortie est compensée par une polarisation de la grille du transistor de sortie à une tension supérieur à la tension de sortie. Néanmoins, la tension de sortie est utilisée par la polarisation ce qui ralentit le temps de montée de la tension de sortie.

Au vu de ce qui précède, le but de la présente invention est de proposer un circuit multiplicateur de tension qui résolve les inconvénients dus à la présence de diodes d'isolation (chute de tension, augmentation du temps de montée, voire encombrement supplémentaire imposé par la nécessité de multiplier le nombre d'étages pour pallier à ces inconvénients).

Suivant l'invention, ce but est atteint par un circuit multiplicateur de tension comprenant au moins une première borne d'entrée pour recevoir une tension d'alimentation d'entrée, une borne de sortie pour fournir une tension d'alimentation de sortie multipliée, un oscillateur fournissant sur une sortie un signal d'horloge, un premier condensateur dont une première borne est connectée à la sortie de l'oscillateur, un premier transistor de précharge monté en série entre la deuxième borne du condensateur et la première borne d'entrée pour les connecter quand un signal binaire de précharge est actif, et un transistor d'isolation monté en série entre la deuxième borne du premier condensateur et la borne de sortie pour les connecter quand un signal binaire de décharge est actif, et un circuit de commande de décharge qui fournit le signal binaire de décharge pour que, lorsque le signal binaire de décharge est actif, il est à un potentiel supérieur à la somme du potentiel de la première borne d'entrée et du potentiel le plus élevé du signal d'horloge, caractérisé en ce que le circuit de commande de décharge comporte un premier et un deuxième circuits de décharge, de même type, montés en série, chacun des circuits de décharge produisant un signal de sortie, dont la valeur maximale est supérieure à la valeur maximale d'un signal d'entrée, par pompage, le premier circuit de décharge recevant le signal d'horloge comme signal d'entrée, le deuxième circuit de décharge recevant comme signal d'entrée le signal de sortie du premier circuit de décharge, et le signal de sortie du deuxième circuit de décharge étant le signal binaire de décharge.

L'invention propose donc de remplacer les diodes par des transistors. En utilisant par exemple des transistors à effet de champ de type NMOS, on éliminera les chutes de tensions dues à la présence des diodes, en imposant sur les grilles de commande de ces transistors des signaux binaires de commande étant à un potentiel supérieur au potentiel à transférer (potentiel de la tension d'alimentation pour précharger un étage, potentiel de la sortie de l'étage précédent pour transférer des charges d'un étage à l'autre) quand ils sont actifs. Par actif, on entend un état de signal de commande tel que son potentiel rend les transistors passants.

D'un point de vue temporel, on charge le condensateur au potentiel d'alimentation par le biais du transistor de précharge, le signal d'horloge étant alors à l'état bas ou inactif (en pratique : au potentiel d'une masse). De même on préchargera la borne de sortie d'une manière équivalente. Puis, quand le signal d'horloge est au potentiel d'alimentation (état actif), on rend passant le transistor d'isolation, le potentiel de sortie étant augmenté par transfert de charge, étant entendu que la borne de sortie est un noeud capacitif. La précharge de la borne de sortie est particulièrement intéressante car elle permet de diminuer le temps de montée du potentiel de sortie.

L'invention sera mieux comprise et d'autres particularités et avantages apparaîtront à la lecture de la description détaillée ci-après d'un exemple de réalisation préféré. Cette description n'est donnée qu'à titre indicatif et nullement limitatif à l'invention, et est illustré par les figures suivantes :
- figure 1 : circuit multiplicateur de tension réalisé conformément à l'invention,
- figure 2 : circuit de décharge utilisé pour produire le signal de décharge,
- figures 3a à 3g : chronogrammes de signaux de commande reçus ou produits par le circuit pour mettre en oeuvre l'invention,
- figures 4a à 4e : chronogrammes de signaux analogiques produits par le circuit multiplicateur de tension.

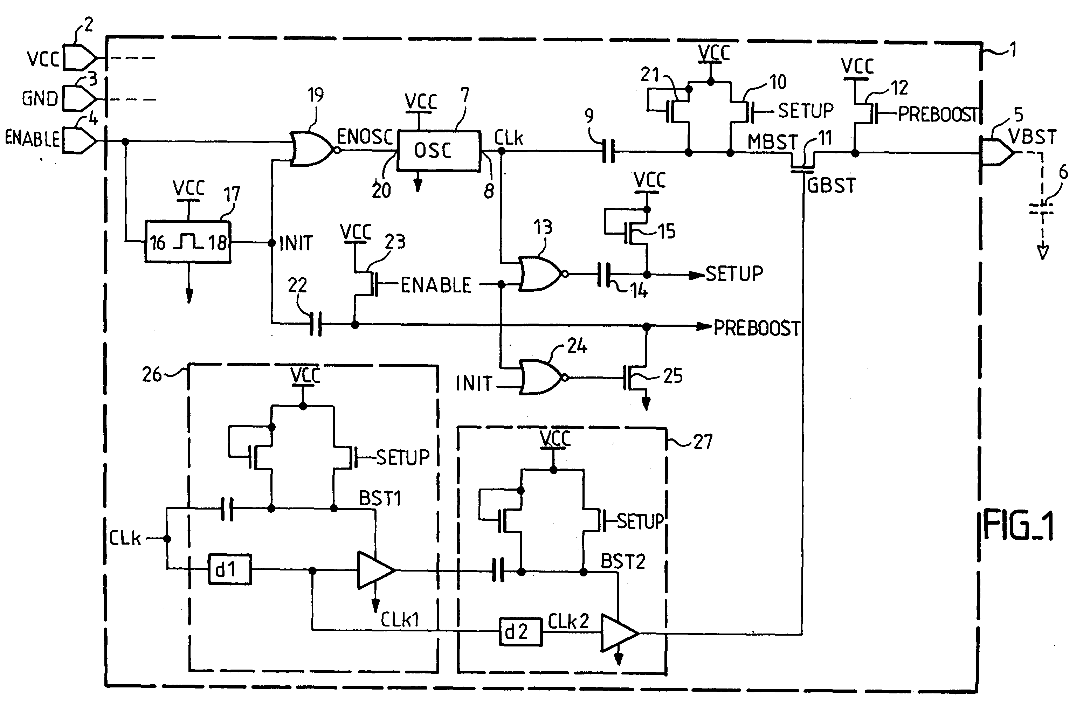

La figure 1 illustre un circuit multiplicateur de tension 1.

Ce circuit multiplicateur de tension 1 comprend :
- une première borne d'entrée 2 pour recevoir une tension d'alimentation d'entrée VCC,
- une deuxième borne d'entrée 3 pour recevoir une tension de référence GND,
- une troisième borne d'entrée 4 pour recevoir un signal d'utilisation ENABLE, et
- une borne de sortie 5 pour fournir une tension d'alimentation VBST multipliée.

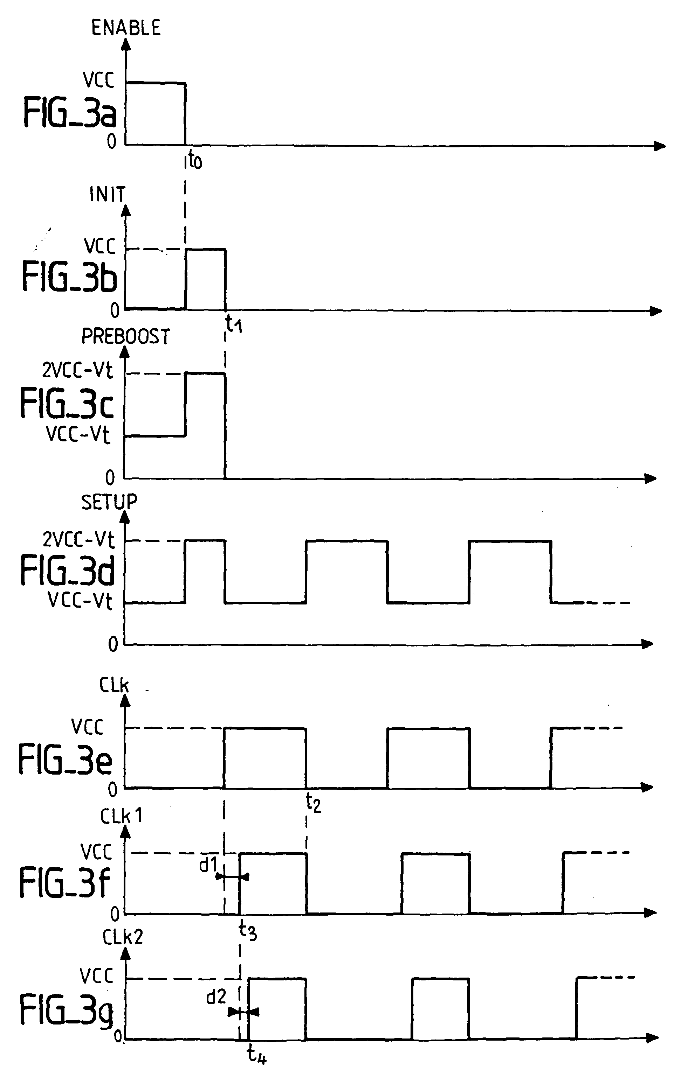

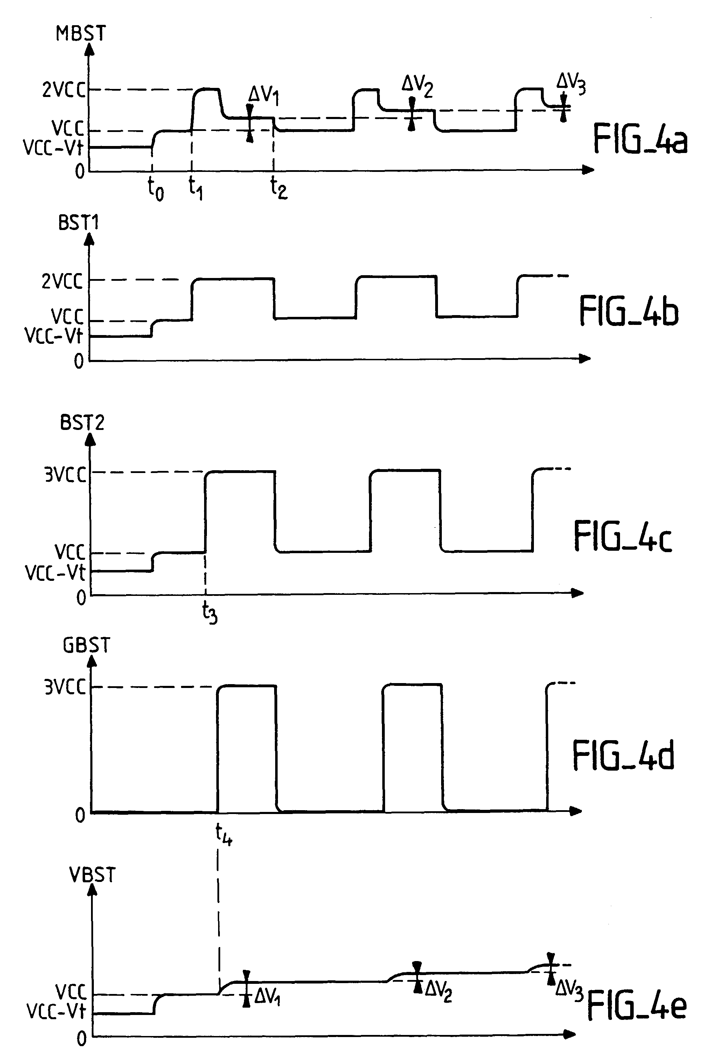

En pratique, la deuxième borne d'entrée 3 est une masse (potentiel 0 sur les chronogrammes des figures 3 et 4). Dans un exemple, VCC vaut par exemple 3 volts.

La borne de sortie 5 est un noeud capacitif et alimente un circuit représenté symboliquement par un condensateur de sortie 6 connecté entre cette borne de sortie 5 et la borne de référence 3 (représentée par un symbole de masse).

Le circuit 1 comporte également un oscillateur 7 fournissant sur une sortie 8 un signal d'horloge CLK. Ce signal d'horloge CLK, représenté à la figure 3e, oscille entre le potentiel de masse 0 (état inactif) et le potentiel d'alimentation VCC (état dit actif).

Cet oscillateur 7 fournit le signal d'horloge CLK quand un signal binaire de commande ENOSC de l'oscillateur est à l'état logique 1 (signal dit actif), le signal fourni à la sortie 8 étant au potentiel 0 si ce signal de commande ENOSC est à l'état logique 0 (signal dit inactif).

La sortie 8 de l'oscillateur 7 est connectée à une borne d'un premier condensateur 9. La deuxième borne de ce condensateur 9 est connectée au drain d'un transistor de précharge 10 dont la source est connectée à la borne d'alimentation 2. On appelle MBST le potentiel de cette deuxième borne du condensateur (illustré figure 4a).

Dans l'exemple de réalisation décrit, on considèrera que les circuits sont réalisés en technologie MOS.

Ce transistor de précharge 10 permet de porter le potentiel MBST à VCC quand le signal d'horloge CLK est inactif (potentiel 0).

La deuxième borne du condensateur 9 est par ailleurs connectée à la source d'un transistor d'isolation 11 dont le drain est connecté à la borne de sortie 5.

Ce transistor d'isolation 11 est rendu passant quand le signal d'horloge CLK est actif afin de transférer des charges du condensateur 9 à la borne de sortie 5.

Le drain du transistor d'isolation 11 est connecté à la borne d'alimentation 2 par le biais d'un transistor de précharge 12.

La figure 3a illustre le signal d'initialisation ENABLE. Quand ce signal est au niveau logique 1 (potentiel VCC) il est dit inactif. Le circuit 1 est alors agencé pour que le potentiel VBST (illustré à la figure 4e) de la borne de sortie 5 soit stable (nonobstant les pertes dues aux circuits alimentés par cette borne de sortie 5). Quand le signal ENABLE passe au niveau logique 0 (potentiel 0), il est dit actif et on charge alors la borne de sortie 5 à l'aide du condensateur 9 par le biais du transistor d'isolation 11.

Dans l'exemple décrit, les transistors de précharge 10 et d'isolation 11 sont des transistors à effet de champ de type N.

La grille de commande du transistor de précharge 10 reçoit un signal binaire de précharge SETUP illustré sur la figure 3d. Pour produire ce signal de précharge SETUP, on utilise une porte NON OU 13 à deux entrées. Cette porte NON OU 13 reçoit sur ses entrées, le signal d'horloge CLK et le signal d'initialisation ENABLE. La sortie de cette porte NON OU est connectée à une première borne d'un deuxième condensateur 14. La deuxième borne de ce condensateur 14 est connectée à la borne d'alimentation 2 par le biais d'un transistor à effet de champ de type N 15 monté en diode. C'est la deuxième borne du condensateur 14 qui fournit le signal de précharge SETUP.

Tant que le signal de précharge SETUP est inactif, la sortie de la porte NON OU est au potentiel 1 (c'est-à-dire VCC) et le signal SETUP est au potentiel VCC - Vt, en appelant Vt la tension de seuil du transistor 15. On dira que ce potentiel VCC - Vt correspond à un état inactif du signal de précharge SETUP. Le transistor de précharge 10 est alors bloqué.

Si on active à un instant t₀ le signal d'initialisation ENABLE, alors le signal de précharge SETUP est porté au potentiel 2 * VCC - Vt par le condensateur 14. Le transistor de précharge 10 devient donc passant et la deuxième borne du condensateur 9 est portée au potentiel VCC. On élimine ainsi l'inconvénient des circuits de type Schenkel dans lesquels le potentiel de précharge est limité à VCC - Vt.

Pour que le circuit permette de porter la tension de sortie VBST à 2 * VCC, il est bien sûr nécessaire que le signal d'horloge CLK soit inactif durant la précharge du condensateur 9.

Pour ce faire, on procède de la manière suivante :
- la borne d'entrée est connectée à l'entrée 16 d'une bascule monostable 17 de manière à ce qu'à l'instant t₀, cette bascule monostable produise une impulsion positive sur une sortie 18. Cette sortie 18 de la bascule monostable 17 produit un signal d'initialisation de précharge de sortie INIT, illustré sur la figure 3b. Ce signal INIT est binaire et est soit au potentiel 0 (état inactif), soit au potentiel VCC (état actif). A t₀, le signal INIT passe à l'état actif et à un instant t₁ ultérieur, il repasse à l'état inactif.
- la sortie 18 de la bascule monostable 17 est connectée à une entrée d'une porte NON OU 19 à deux entrées. L'autre entrée de cette porte NON OU 19 reçoit le signal d'initialisation ENABLE. La sortie de cette porte 19 est connectée à une entrée 20 de l'oscillateur 7 et lui fournit le signal de commande ENOSC. Ainsi, tant que les signaux d'initialisation ENABLE et INIT sont au potentiel VCC, le signal d'horloge CLK est maintenu au potentiel 0.

A l'instant t₁, l'oscillateur 7 est mis en fonctionnement et le signal d'horloge CLK commence à osciller entre VCC et 0, en opposition de phase avec le signal de précharge SETUP. Quand le signal de précharge SETUP est actif, le potentiel MBST est porté à VCC, puis à 2VCC quand le signal d'horloge passe à l'état actif, le transistor de précharge 10 étant alors bloqué.

Pour diminuer le temps de montée du potentiel MBST, on aura intérêt à ce que l'intervalle de temps t₁ - t₀ soit le plus court possible, tout en étant suffisant pour qu'il atteigne le potentiel VCC. Pour ce faire, on connecte la deuxième borne du condensateur 9 à la borne d'alimentation 2 par le biais d'un transistor à effet de champ de type N 21, monté en diode. Ainsi, le potentiel MBST est égal à VCC - Vt (on suppose que tous les transistors ont la même tension de seuil) quand le signal d'initialisation ENABLE est inactif. En pratique, l'intervalle de temps t₁ - t₀ est déterminé par le choix d'une valeur de résistance et d'un valeur de capacité associées à la bascule monostable.

Le signal d'initialisation de précharge de sortie INIT est également utilisé pour précharger la borne de sortie 5 et pour porter son potentiel VBST à VCC. Pour ce faire, on produit un signal de commande de précharge de sortie PREBOOST appliqué à la grille de commande du transistor de précharge 12, de telle manière que ce transistor 12 soit passant tant que le signal INIT est actif.

De même que pour le signal de précharge SETUP, on va porter le signal de précharge de sortie PREBOOST (illustré figure 3c) au potentiel 2 * VCC - Vt entre les instants t₀ et t₁. Pour ce faire, on connecte la sortie 18 de la bascule monostable 17 à une première borne d'un condensateur 22. L'autre borne de ce condensateur 22 est connectée à la borne d'alimentation 2 par le biais d'un transistor à effet de champ de type N 23, dont la grille de commande reçoit le signal d'initialisation ENABLE. Le signal de précharge de sortie PREBOOST est le signal présent sur la deuxième borne de ce transistor 23.

Tant que le signal d'initialisation ENABLE est inactif, le signal PREBOOST est au potentiel VCC - Vt. A l'instant t₀, le signal INIT passe au potentiel VCC et le potentiel du signal PREBOOST est donc porté à 2 * VCC -Vt.

A l'instant t₁, le transistor de précharge 12 est bloqué, ce qui isole la borne de sortie 5 de la borne d'alimentation 2 et autorise la montée à 2 * VCC du potentiel VBST. On pourra prévoir de descendre alors le signal PREBOOST au potentiel 0. Il suffit pour cela de connecter la deuxième borne du condensateur 22 à la masse par le biais d'un transistor à effet de champ de type N 25. La grille de commande de ce transistor 25 est connectée à la partie d'une porte NON OU 24 à deux entrées, qui reçoit les signaux d'initialisation ENABLE et INIT sur ses entrées. On notera que, par le biais du transistor 23 (équivalent à une diode quand ENABLE est inactif), on diminue le temps de montée à VCC du potentiel VBST, de la même manière que pour monter le potentiel MBST à VCC (à l'aide du transistor 21).

Après avoir décrit la précharge du condensateur 9 et de la borne de sortie 5 (ou du condensateur 6, ce qui revient au même), on va maintenant décrire comment on augmente le potentiel VBST, par transfert de charge entre le condensateur 9 et la borne de sortie 5.

Pour décharger le condensateur 9 sur la borne de sortie 5, on rend le transistor d'isolation 11 passant une fois que le potentiel MBST a été monté à 2 * VCC. Une fois la décharge réalisée, on bloque ce transistor 11 et on charge à nouveau le condensateur 9.

Pour bloquer ou rendre passant le transistor de décharge 11, on applique un signal binaire de commande de charge GBST (illustré la figure 4d) sur sa grille de commande.

Pour que le transfert de charge s'effectue sans pertes, il est nécessaire que le signal de charge GBST soit supérieur à 2 * VCC quand on désire rendre le transistor d'isolation 11 passant.

Pour ce faire, on va utiliser des circuits de commande de charge 26 et 27 mettant en oeuvre le même principe de fonctionnement que les circuits de précharge et de charge décrits précédemment et qui mettent en oeuvre des condensateurs.

Le principe consiste à utiliser un circuit de commande de charge permettant de produire un signal de sortie pouvant atteindre un potentiel supérieur à un signal reçu en entrée. Typiquement, on produit donc une différence de potentiel de VCC entre le signal d'entrée et le signal de sortie.

Le premier circuit de commande de charge 26 va recevoir le signal d'horloge CLK en entrée et va produire un signal d'horloge en sortie qui est compris entre 0 et 2 * VCC. Ce dernier signal d'horloge est fourni à un circuit de commande de charge 27, monté en série avec le premier, et qui va produire le signal GBST qui pourra monter à 3 * VCC.

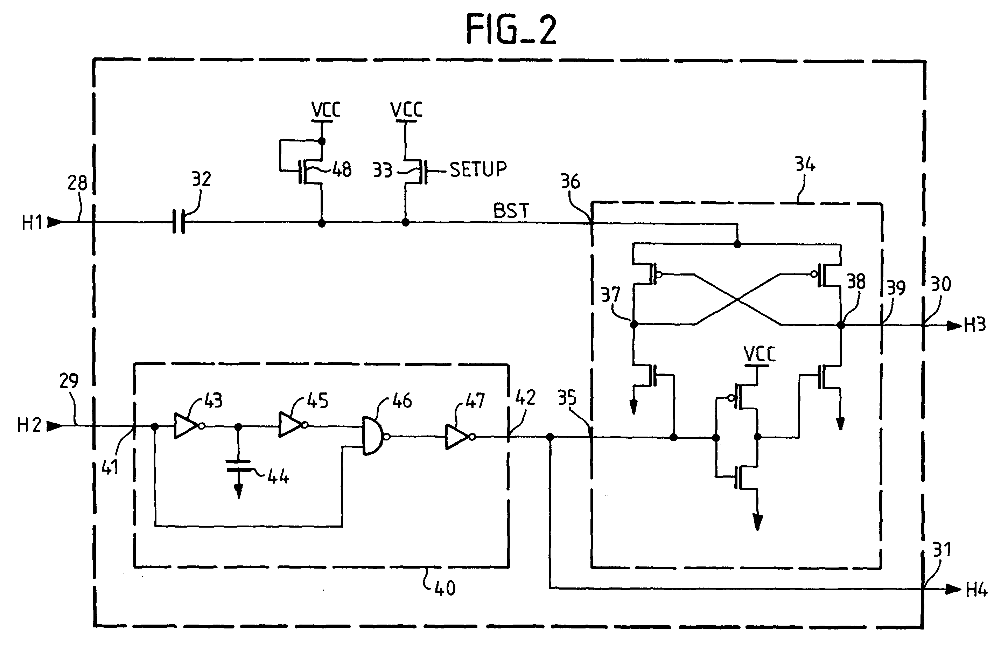

Un circuit de commande de charge est décrit sur la figure 2.

Il comprend :
- une première entrée 28 pour recevoir un premier signal d'horloge d'entrée H1,
- une deuxième entrée 29 pour recevoir un second signal d'horloge d'entrée H2,
- une première sortie 30 pour fournir un premier signal d'horloge de sortie H3, et
- une deuxième sortie 31 pour fournir un second signal d'horloge de sortie H4.

En pratique, le premier et le second signaux d'horloge d'entrée peuvent prendre 2 valeurs : soit le potentiel de référence 0 (état inactif), soit un potentiel multiple de VCC (état actif).

Supposons par exemple que le signal d'horloge d'entrée H1 soit compris entre 0 et m * VCC avec m un entier.

L'entrée 28 est connectée à la première borne d'un condensateur 32. La deuxième borne de ce condensateur 32 est connectée à la borne d'alimentation 2 par le biais d'un transistor de précharge à effet de champ de type N 33 recevant le signal de précharge SETUP sur sa grille de commande.

On appellera BST le potentiel de la seconde borne du condensateur 31. BST est une tension d'alimentation interne pompée (interne par distinction avec la tension VBST formée en sortie). En s'arrangeant de manière à ce que le premier signal d'horloge d'entrée H1 soit inactif pendant l'intervalle de temps durant lequel le signal de précharge SETUP est actif, on peut ainsi précharger le condensateur à BST = VCC. Puis, quand le signal H1 sera actif, le condensateur sera chargé et BST va monter à (m + 1) * VCC.

On va par ailleurs utiliser un commutateur 34 pour produire le premier signal d'horloge de sortie afin que celui-ci oscille entre 0 et (m + 1) * VCC.

Pour ce faire, ce commutateur 34 reçoit sur une entrée 35, le deuxième signal d'horloge de sortie H4, ce signal pouvant être au potentiel 0 ou au potentiel VCC.

Ce signal d'horloge H4 est appliqué à l'entrée d'un inverseur composé de deux transistors de type respectivement P et N montés en série entre la borne d'entrée d'alimentation 2 et la borne de référence 3. Cet inverseur délivre donc sur sa sortie un signal oscillant entre 0 et VCC, en opposition de phase avec le second signal d'horloge de sortie H4.

Le commutateur 34 comporte par ailleurs deux branches composées de deux transistors de type respectivement P et N montés en série entre une entrée 36 et la borne de référence 3. L'entrée 36 est connectée à la deuxième borne du condensateur 32 et se trouve donc au potentiel BST.

Le transistor de type N de la première branche 37 a sa grille de commande connectée à l'entrée de l'inverseur, alors que le transistor de type N de la seconde branche 38 a sa grille de commande connectée à la sortie de l'inverseur.

Le transistor de type P de la première branche 37 a sa grille de commande connectée au point milieu des transistors de la seconde branche 38. Le transistor de type P de la seconde branche 38 a sa grille de commande connectée au point milieu des transistors de la première branche 37.

Le commutateur 34 comporte enfin une sortie 39 connectée au point milieu des transistors de la seconde branche, cette sortie 39 étant connectée à la sortie 30 du commutateur 34.

En recevant un deuxième signal d'horloge de sortie H4 qui est inactif (potentiel 0) quand le premier signal d'horloge d'entrée H1 est inactif (potentiel 0), le commutateur 34 va donc produire un signal de sortie (premier signal d'horloge de sortie H3 du circuit de commande de charge) qui est au potentiel 0. Quand le premier signal d'horloge d'entrée H1 est actif, si le second signal d'horloge de sortie H4 passe à l'état actif, le premier signal d'horloge de sortie H3 va monter au potentiel de (m + 1) * VCC.

On pourrait utiliser des signaux d'horloge H1 et H4 identiques. En pratique, on préférera retarder le passage à l'état actif du second signal d'horloge de sortie H4 afin de laisser le temps au condensateur de porter le potentiel VBST à (m + 1) * VCC, ce qui n'est pas immédiat.

Pour ce faire, on produit le second signal l'horloge de sortie H4 à partir du premier signal d'horloge d'entrée H2 de la manière décrite ci-dessous.

L'entrée 29, qui reçoit H2, est connectée à une entrée 41 d'un circuit de retardement 40, ce circuit fournissant le second signal d'horloge de sortie H4 sur une sortie 42. L'entrée 41 du circuit de retardement 40 est connectée à un inverseur 43 dont la sortie est connectée à une borne d'un condensateur 44 dont l'autre borne est connectée à la borne de référence 3.

La sortie de l'inverseur 43 est connectée par ailleurs à l'entrée d'un inverseur 45. La sortie de cet inverseur 45 est connectée à une entrée d'une porte NON ET 46 à deux entrées. L'autre entrée de cette porte NON ET 46 est connectée à l'entrée 41 du circuit de retardement 40, et sa sortie est connectée à la sortie 42 de ce circuit 40 par le biais d'un inverseur 47.

Ainsi, quand le signal d'horloge d'entrée H2 passe de l'état inactif à l'état actif, le signal d'horloge de sortie H4 reste à l'état inactif pendant un certain délai du à la décharge progressive du condensateur 44.

On notera que quand le signal d'horloge d'entrée H2 bascule dans l'autre état, le second signal d'horloge de sortie H2 passe simultanément à l'état inactif, par le biais de la porte NON ET 46.

Si les signaux d'horloge d'entrée H1 et H2 sont synchrones et simultanément dans le même état (actif ou inactif), les signaux d'horloge du sortie H3 et H4 seront eux-mêmes synchrones et simultanément dans le même état.

On aura simplement modifié le rapport cyclique des signaux d'horloge de sortie par rapport à celui des signaux d'horloge d'entrée, de manière à retarder le passage à l'état actif des signaux d'horloge de sortie.

Comme on a dit que le second signal d'horloge de sortie H4 oscillait entre 0 et VCC, il en est bien évidemment de même pour le second signal d'horloge d'entrée H2 et on alimente les circuits logiques du circuit de retardement 40 entre les bornes d'alimentation 2 et de référence 3.

On notera qu'on pourra connecter la deuxième borne du condensateur 32 à la borne d'alimentation 2 par le biais d'un transistor à effet de champ de type N 48, monté en diode. Cela permet de ne pas descendre le potentiel BST au-dessous de VCC - Vt afin de diminuer le temps de précharge de ce condensateur 32.

Dans le circuit 1, réalisé suivant l'invention, on utilise deux circuits de commande de charge 26 et 27 montés en série.

Le premier circuit 26 reçoit le signal d'horloge CLK sur ses deux entrées. La première sortie de ce circuit 26 est connectée à la première entrée du second circuit de commande de charge 27. Le second circuit 27 a sa seconde entrée connectée à la seconde sortie du premier circuit 26, et sa sortie connectée à la grille de commande du transistor d'isolation 11.

La figure 3f illustre l'évolution temporelle du second signal d'horloge de sortie, noté CLK1, du premier circuit de commande de charge 26.

La figure 3g illustre l'évolution temporelle du second signal d'horloge de sortie, noté CLK2, du second circuit de commande de charge 27.

La figure 4b illustre l'évolution temporelle du potentiel, noté BST1, de la seconde borne du condensateur du premier circuit de commande de charge 26.

La figure 4c illustre l'évolution temporelle du potentiel, noté BST2, de la seconde borne du condensateur du second circuit de commande de charge 27.

Jusqu'à l'instant t₀, les potentiels BST1 et BST2 sont à VCC - Vt. A l'instant t₀, le signal de précharge SETUP est activé et ces potentiels sont portés à VCC.

A l'instant t₁, le signal d'horloge CLK est activé. A un instant t₃ ultérieur, le signal d'horloge CLK1 est activé avec un retard d₁ = t₃ - t₁ par rapport au signal d'horloge CLK. A cet instant t₃, le potentiel BST1 est donc monté à 2VCC. A un instant t₄, ultérieur à t₃, le signal d'horloge CLK2 est activé avec un retard d₂ = t₄ - t₃ par rapport au signal d'horloge CLK2. A cet instant t₄, le potentiel BST2 est donc monté à 3VCC.

Quand le signal d'horloge CLK repasse à l'état inactif (instant t₂), les signaux d'horloge CLK1 et CLK2 sont inactivés simultanément.

Le signal de commande de charge GBST, initialement au potentiel 0, est ainsi monté à 3 * VCC à l'instant t₄ et reste à ce potentiel jusqu'à l'instant t₂. Bien entendu, il faut que l'instant t₂ soit ultérieur à l'instant t₄, sans quoi le signal de commande de charge serait constamment au potentiel 0 et le transistor de charge 11 serait constamment bloqué, ce qui n'aurait pas de sens.

Dans un exemple, on considère un signal d'horloge CLK de rapport cyclique 1/2 et ayant une période de 100 nanosecondes. Bien entendu, la détermination de ces retards tiendra compte des valeurs des capacités des condensateurs employés. On pourra se limiter à quelques picofarads pour les condensateurs des circuits de commande de charge 26 et 27, étant entendu que ces condensateurs sont utilisés pour produire un signal de commande en tension (pour la polarisation du transistor 11), et n'ont pas pour but de fournir un courant important. Il suffira de produire des retards d₁ et d₂ de quelques nanosecondes. Néanmoins, il faudra tenir compte du transfert de charge entre les circuits de commande de charge montés en série.

En ce qui concerne la tension d'alimentation de sortie VBST, initialement portée au potentiel VCC à l'instant t₀, elle va augmenter et passer de VCC à VCC + ΔV1 (ΔV1 > 0) à l'instant t₄, le transistor d'isolation devenant alors passant.

En effet, le potentiel MBST est alors à 2 * VCC et le condensateur 9 se déchargera alors sur la borne de sortie, pour charger le condensateur équivalent 6. MBST va donc descendre à VCC + ΔV1.

On notera qu'il convient de préférence de déterminer les délais d₁ et d₂ de telle manière que le condensateur 9 ait eu le temps d'être chargé à 2 * VCC, sans quoi on diminuera le temps de montée de la tension de sortie VBST.

En répétant le processus, la tension de sortie VBST va progressivement être augmentée d'une valeur ΔVₙ à chaque nième cycle d'horloge, pour tendre asymptotiquement vers 2 * VCC. Les ΔVₙ vont progressivement diminuer en amplitude. Suivant la valeur qu'on souhaitera atteindre en un temps donné, on pourra, connaissant la valeur approximative de la capacité du condensateur équivalent, déterminer en conséquence la valeur de la capacité du condensateur 9 et le nombre de cycle d'horloge nécessaire.

On essaiera, dans la mesure du possible, d'utiliser un condensateur 9 ayant une capacité importante pour diminuer le temps nécessaire pour amener la tension de sortie à la valeur désirée. En pratique, on est limité par la taille du circuit et il est difficile d'égaliser les capacités des condensateurs 9 et 6, ce dernier atteignant typiquement une valeur de quelques centaines de picofarads.

On notera qu'on a considéré un signal de précharge SETUP qui est en opposition de phase par rapport au signal d'horloge CLK, ce qui n'est pas obligatoire. On pourrait utiliser un signal de précharge SETUP qui soit actif pendant un intervalle de temps plus court, du moment que celui-ci n'est pas actif lorsque le signal d'horloge CLK est actif, auquel cas les condensateurs se déchargeraient dans la borne d'alimentation 2.

On pourrait également utiliser des circuits de commande de charge 26 et 27 sans inverseur entre leur sortie et la sortie de leur porte NON ET, étant entendu qu'ils sont en nombre pair. Cela permet de diminuer l'encombrement général du circuit. C'est d'ailleurs pour diminuer cet encombrement qu'on utilisera de préférence les transistors de type N plutôt que des transistors de type P.

D'un point de vue plus général, les solutions proposées par l'invention sont facilement applicables aux pompes de type Schenkel à plusieurs étages. De même, on pourrait envisager de réaliser un circuit multiplicateur de tension comportant plusieurs condensateurs en série, de manière analogue au principe mis en oeuvre dans les circuits de commande de charge. Un tel circuit présenterait néanmoins l'inconvénient d'augmenter le temps de montée de la tension de sortie produite, le gain total du circuit et donc le nombre de charges transférées au total, diminuant au fur et à mesure que l'on rajouterait des étages.

## Revendications

1. Circuit multiplicateur de tension (1) comprenant au moins une première borne d'entrée (2) pour recevoir une tension d'alimentation d'entrée (VCC), une borne de sortie (5) pour fournir une tension d'alimentation de sortie (VBST) multipliée, un oscillateur (7) fournissant sur une sortie (8) un signal d'horloge (CLK), un premier condensateur (9) dont une première borne est connectée à la sortie de l'oscillateur (7), un premier transistor de précharge (10) monté en série entre la deuxième borne du condensateur et la première borne d'entrée pour les connecter quand un signal binaire de précharge est actif (SETUP), et un transistor d'isolation (11) monté en série entre la deuxième borne du premier condensateur (9) et la borne de sortie (5) pour les connecter quand un signal binaire de décharge (GBST) est actif, et un circuit de commande de décharge (26 et 27) qui fournit le signal binaire de décharge (GBST) pour que, lorsque le signal binaire de décharge (GBST) est actif, il est à un potentiel supérieur à la somme du potentiel de la première borne d'entrée (2) et du potentiel le plus élevé du signal d'horloge (CLK), caractérisé en ce que le circuit de commande de décharge (26 et 27) comporte un premier et un deuxième circuits de décharge (26, 27), de même type, montés en série, chacun des circuits de décharge (26, 27) produisant un signal de sortie (H3), dont la valeur maximale est supérieure à la valeur maximale d'un signal d'entrée (H1), par pompage, le premier circuit de décharge (26) recevant le signal d'horloge (CLK) comme signal d'entrée (H1), le deuxième circuit de décharge (27) recevant comme signal d'entrée (H1) le signal de sortie (H3) du premier circuit de décharge (26), et le signal de sortie (H3) du deuxième circuit de décharge (27) étant le signal binaire de décharge (GBST).

2. Circuit selon la revendication 1, caractérisé en ce qu'il comporte des moyens de commande de précharge (13 à 15) pour produire le signal de précharge (SETUP) de telle façon que ce signal de précharge (SETUP) soit actif quand le signal d'horloge (CLK) est inactif et qu'il soit inactif quand le signal d'horloge (CLK) est actif.

3. Circuit selon la revendication 2, caractérisé en ce que:
- il comporte une deuxième borne d'entrée (4) pour recevoir un signal binaire d'initialisation (ENABLE),
- les moyens de commande de précharge (13 à 15) comportent une porte NON OU (13) à deux entrées et un deuxième condensateur (14),
- la porte NON OU (13) reçoit le signal d'horloge (CLK) sur sa première entrée et le signal d'initialisation (ENABLE) sur son autre entrée,
- la sortie de la porte NON OU (13) est connectée à une première borne du deuxième condensateur (14),
- une deuxième borne de ce condensateur (14) est connectée d'une part à la cathode d'une diode (15) dont l'anode est connectée à la première borne d'entrée (2), et d'autre part à la grille de commande du premier transistor de précharge (10).

4. Circuit selon l'une des revendications 1 à 3, caractérisé en ce que le circuit de commande de décharge (26 et 27) produit le signal de décharge (GBST) de telle façon que le signal de décharge (GBST) soit actif quand le signal d'horloge (CLK) est actif et qu'il soit inactif quand le signal d'horloge (CLK) est inactif.

5. Circuit selon l'une des revendications 1 à 4, caractérisé en ce que les premier et deuxième circuits de décharge (26, 27) comportent chacun:
- une première entrée (28) pour recevoir le signal d'entrée (H1),
- une deuxième entrée (29) pour recevoir un signal d'horloge d'entrée (H2),
- une première sortie (30) pour fournir le signal de sortie (H3),
- une deuxième sortie (31) pour fournir un signal d'horloge de sortie (H4),
et en ce que :
- à partir du signal d'entrée (H1), le circuit de décharge (26 ou 27) produit une tension d'alimentation interne pompée (BST),
- le signal d'horloge de sortie (H4) est inactif quand le signal d'horloge d'entrée (H2) est inactif et il passe à l'état actif avec un certain délai après que le signal d'horloge d'entrée (H2) passe à l'état actif,
- le signal de sortie (H3) est au potentiel de la tension d'alimentation interne pompée (BST) quand le signal d'horloge de sortie (H4) est actif, et à un potentiel de référence (GND) fourni par une troisième borne d'entrée (3) si le signal d'horloge de sortie (H4) est inactif.

6. Circuit selon la revendication 5, caractérisé en ce que chaque circuit de décharge (26 ou 27) comprend:
- un troisième condensateur (32) dont une borne est connectée à la première entrée (28) du circuit de décharge (26 ou 27), et dont l'autre borne est connectée à la première borne d'entrée (2) par le biais d'un deuxième transistor de précharge (33) à effet de champ dont la grille de commande reçoit le signal de commande de précharge (SETUP),
- un commutateur (34) comprenant une entrée (35) pour recevoir le signal d'horloge de sortie (H4), et une sortie (39) pour connecter sélectivement la première sortie (30) du circuit de décharge (26 ou 27) à la deuxième borne du troisième condensateur (32) ou à la troisième borne d'entrée (3).

7. Circuit suivant l'une des revendications 5 à 6, caractérisé en ce que les premier et deuxième circuits de décharge (26, 27) sont montés en série de telle façon que
- le premier circuit de décharge (26) reçoit le signal d'horloge (CLK) sur ses deux entrées (28, 29),
- la première entrée (28) du second circuit de décharge (27) est connectée à la première sortie (30) du premier circuit de décharge (26),
- la deuxième entrée (29) du second circuit de décharge (27) est connectée à la deuxième sortie (31) du premier circuit de décharge (26),
et en ce que la première sortie (28) du deuxième circuit de décharge (27) est connectée à la grille de commande du transistor d'isolation (11).

8. Circuit selon l'une des revendications 1 à 7, caractérisé en ce qu'il comporte un transistor de précharge de sortie (12) pour connecter la borne de sortie (15) à la première borne d'entrée (2) quand un signal d'initialisation de précharge de sortie (INIT) est actif.

9. Circuit selon la revendication 8, caractérisé en ce qu'il comporte des moyens de commande de précharge de sortie (16 à 18) pour produire le signal d'initialisation de précharge de sortie (INIT) de telle manière que :
- celui-ci passe de l'état inactif à l'état actif quand le signal d'initialisation (ENABLE) passe de l'état inactif à l'état actif,
- ce signal de précharge de sortie (INIT) passe à l'état inactif après un certain délai,
- un signal de commande d'oscillateur (ENOSC) est inactif tant que le signal d'initialisation (ENABLE) est inactif ou que le signal de précharge de sortie (INIT) est actif.

10. Circuit selon la revendication 9, caractérisé en ce que les moyens de commande de précharge de sortie (16 à 18) comprennent une bascule monostable (17) comprenant une entrée (16) connectée à la deuxième borne d'entrée (4) et une sortie (18) connectée à la première borne d'un quatrième condensateur (22), la deuxième borne de ce condensateur (22) étant connectée à
- la première borne d'entrée (2) par le biais d'un troisième transistor de précharge (23) recevant le signal d'initialisation (ENABLE) sur sa borne de commande,
- la troisième borne d'entrée (3) par le biais d'un transistor (25) dont la grille de commande est connectée à la sortie d'une porte NON OU (24) à deux entrées recevant sur ses entrées le signal d'initialisation (ENABLE) et le signal d'initialisation de précharge de sortie (INIT),
- et à la grille de commande du transistor de précharge de sortie (12).

11. Circuit selon l'une des revendications 9 à 10, caractérisé en ce que l'oscillateur (7) reçoit le signal de commande d'oscillateur (ENOSC) fourni par la sortie d'une porte NON OU (19) à deux entrées dont les entrées reçoivent le signal d'initialisation (ENABLE) et le signal d'initialisation de précharge de sortie (INIT), l'oscillateur (7) fournissant le signal d'horloge (CLK) quand ce signal de commande (ENOSC) est actif.

12. Circuit selon l'une des revendications 1 à 11, caractérisé en ce que les transistors de précharge (10, 12, 33) sont des transistors de type N.

13. Circuit selon l'une des revendications 1 à 12, caractérisé en ce que le signal binaire de précharge (SETUP), quand il est actif, est à un potentiel supérieur au potentiel de la première borne d'entrée (2).

14. Circuit selon l'une des revendications 1 à 13, caractérisé en ce qu'il comporte des transistors montés en diode (21, 48), connectés en parallèle avec les transistors de précharge (10, 31).

15. Mémoire électriquement programmable, caractérisée en ce qu'elle comprend un circuit multiplicateur de tension (1) défini selon d'une des revendications 1 à 14.

## Patentansprüche

1. Spannungsvervielfacherschaltung (1) mit wenigstens einem ersten Eingangsanschluß (2) zum Empfangen einer Eingangsversorgungsspannung (VCC), einem Ausgangsanschluß (5) zum Ausgeben einer vervielfachten Ausgangsversorgungsspannung, einem Oszillator (7), der an einem Ausgang (8) ein Taktsignal (CLK) ausgibt, einem ersten Kodensator (9), von dem ein Anschluß an den Ausgang des Oszillators (7) angeschlossen ist, einem ersten Vorladetransistor (10), der in Reihe zwischen den zweiten Anschluß des Kondensators und den ersten Eingangsanschluß geschaltet ist, um diese zu verbinden, wenn ein binäres Vorladesignal (SETUP) aktiv ist, und einem Trenntransistor (11), der in Reihe zwischen den zweiten Anschluß des ersten Kondensators (9) und den Ausgangsanschluß (5) geschaltet ist, um diese zu verbinden, wenn ein binäres Entladesignal (GBST) aktiv ist, und einer Entladesteuerschaltung (26 und 27), die das binäre Entladesignal (GBST) ausgibt, so daß, wenn das binäre Entladesignal (GBST) aktiv ist, es ein höheres Potential als die Summe des Potentials des ersten Eingangsanschlusses (2) und des höchsten Potentials des Taktsignals (CLK) hat,
dadurch **gekennzeichnet,** daß
die Entladesteuerschaltung (26 und 27) eine erste und eine zweite Entladeschaltung (26, 27) von gleicher Art in Reihe geschaltet umfaßt, wobei jede der Entladeschaltungen (26, 27) ein Ausgangssignal (H3) erzeugt, dessen Maximalwert durch Pumpen höher als der Maximalwert eines Eingangssignals (H1) ist, wobei die erste Entladeschaltung (26) das Taktsignal (CLK) als Eingangssignal (H1) empfängt und die zweite Entladeschaltung (27) als Eingangssignal (H1) das Ausgangssignal (H3) der ersten Entladeschaltung (26) empfängt und das Ausgangssignal (H3) der zweiten Entladeschaltung (27) das binäre Entladesignal (GBST) ist.

2. Schaltung nach Anspruch 1,
dadurch gekennzeichnet, daß
sie Vorladesteuereinrichtungen (13 bis 15) umfaßt, um das Vorladesignal (SETUP) so zu erzeugen, daß dieses Vorladesignal (SETUP) aktiv ist, wenn das Taktsignal (CLK) inaktiv ist, und inaktiv ist, wenn das Taktsignal (CLK) aktiv ist.

3. Schaltung nach Anspruch 2,
dadurch gekennzeichnet, daß:
- sie einen zweiten Eingangsanschluß (4) zum Empfangen eines binären Initialisierungssignals (ENABLE) umfaßt,
- die Vorladesteuereinrichtungen (13 bis 15) ein NORGatter (13) mit zwei Eingängen und einen zweiten Kondensator (14) umfassen,
- das NOR-Gatter (13) das Taktsignal (CLK) an seinem ersten Eingang und das Initialisierungssignal (ENABLE) an seinem anderen Eingang empfängt,
- der Ausgang des NOR-Gatters (13) an einen ersten Anschluß des zweiten Kondensators (14) angeschlossen ist,
- ein zweiter Anschluß dieses Kondensators (14) einerseits an die Kathode einer Diode (15), deren Anode an den ersten Eingangsanschluß (2) angeschlossen ist, und andererseits an das Steuer-Gate des ersten Vorladetransistors (10) angeschlossen ist.

4. Schaltung nach einem der Ansprüche 1 bis 3,
dadurch gekennzeichnet, daß
die Entladesteuerschaltung (26 und 27) das Entladesignal (GBST) derart erzeugt, daß das Entladesignal (GBST) aktiv ist, wenn das Taktsignal (CLK) aktiv ist, und es inaktiv ist, wenn das Taktsignal (CLK) inaktiv ist.

5. Schaltung nach einem der Ansprüche 1 bis 4,
dadurch gekennzeichnet, daß
die erste und die zweite Entladeschaltung (26, 27) jeweils aufweisen:
- einen ersten Eingang (28) zum Empfangen des Eingangssignals (H1),
- einen zweiten Eingang (29) zum Empfangen eines Eingangstaktsignals (H2),
- einen ersten Ausgang (30) zum Ausgeben des Ausgangssignals (H3),
- einen zweiten Ausgang (31) zum Ausgeben eines Ausgangstaktsignals (H4),
und daß
- aus dem Eingangssignal (H1) die Entladeschaltung (26 oder 27) eine gepumpte interne Versorgungsspannung (BST) erzeugt,
- das Ausgangstaktsignal (H4) inaktiv ist, wenn das Eingangstaktsignal (H2) inaktiv ist und es in den aktiven Zustand mit einer bestimmten Verzögerung übergeht, nachdem das Eingangstaktsignal (H2) in den aktiven Zustand übergeht,
- das Ausgangssignal (H3) auf dem Potential der gepumpten internen Versorgungsspannung (BST) ist, wenn das Ausgangstaktsignal (H4) aktiv ist, und auf einem durch einen dritten Eingangsanschluß (3) gelieferten Referenzpotential (GND) ist, wenn das Ausgangstaktsignal (H4) inaktiv ist.

6. Schaltung nach Anspruch 5,
dadurch gekennzeichnet, daß
jede Entladeschaltung (26 oder 27) umfaßt:
- einen dritten Kondensator (32), von dem ein Anschluß an den ersten Eingang (28) der Entladeschaltung (26 oder 27) angeschlossen ist, und dessen anderer Anschluß an den ersten Eingangsanschluß (2) über einen zweiten Vorladetransistor (33) mit Feldeffekt angeschlossen ist, dessen Steuergate das Vorladesteuersignal (SETUP) empfängt,
- einen Schalter (34) mit einem Eingang (35) zum Empfangen des Ausgangstaktsignals (H4) und einem Ausgang (39) zum selektiven Verbinden des ersten Ausgangs (30) der Entladeschaltung (26 oder 27) mit dem zweiten Anschluß des dritten Kondensators (32) oder dem dritten Eingangsanschluß (3).

7. Schaltung nach einem der Ansprüche 5 bis 6,
dadurch gekennzeichnet, daß
die erste und die zweite Entladeschaltung (26, 27) so in Reihe geschaltet sind, daß
- die erste Entladeschaltung (26) das Taktsignal (CLK) an seinen zwei Eingängen (28, 29) empfängt,
- der erste Eingang (28) der zweiten Entladeschaltung (27) an den ersten Ausgang (30) der ersten Entladeschaltung (26) angeschlossen ist,
- der zweite Eingang (29) der zweiten Entladeschaltung (27) an den zweiten Ausgang (31) der ersten Entladeschaltung (26) angeschlossen ist,
und daß der erste Ausgang (28) der zweiten Entladeschaltung (27) an das Steuer-Gate des Trenntransistors (11) angeschlossen ist.

8. Schaltung nach einem der Ansprüche 1 bis 7,
dadurch gekennzeichnet, daß
sie einen Ausgangsvorladetransistor (12) umfaßt, um den Ausgangsanschluß (15) mit dem ersten Eingangsanschluß (2) zu verbinden, wenn ein Ausgangsvorladeinitialisierungssignal (INIT) aktiv ist.

9. Schaltung nach Anspruch 8,
dadurch gekennzeichnet, daß
sie Ausgangsvorladesteuereinrichtungen (16 bis 18) umfaßt, um das Ausgangsvorladeinitialisierungssignal (INIT) so zu erzeugen, daß:
- dieses vom inaktiven in den aktiven Zustand übergeht, wenn das Initialisierungssignal (ENABLE) vom inaktiven in den aktiven Zustand übergeht,
- dieses Ausgangsvorladesignal (INIT) nach einer bestimmten Verzögerung in den inaktiven Zustand übergeht,
- ein Oszillatorsteuersignal (ENOSC) inaktiv ist, solange das Initialisierungssignal (ENABLE) inaktiv ist oder das Ausgangsvorladesignal (INIT) aktiv ist.

10. Schaltung nach Anspruch 9,
dadurch gekennzeichnet, daß
die Ausgangsvorladesteuereinrichtungen (16 bis 18) eine monostabile Kippschaltung (17) mit einem an den zweiten Eingangsanschluß (4) angeschlossenen Eingang (16) und einem an den ersten Anschluß eines vierten Kondensators (22) angeschlossenen Ausgang (18) umfassen, wobei der zweite Anschluß dieses Kondensators (22) angeschlossen ist an
- den ersten Eingangsanschluß (2) über einen dritten Vorladetransistor (23), der an seinem Steueranschluß das Initialisierungssignal (ENABLE) empfängt,
- den dritten Eingangsanschluß (3) über einen Transistor (25), dessen Steuer-Gate an den Ausgang eines NOR-Gatters (24) mit zwei Eingängen angeschlossen ist, das an seinen Eingängen das Initialisierungssignal (ENABLE) und das Ausgangsvorladeinitialisierungssignal (INIT) empfängt, und an
- das Steuer-Gate des Ausgangsvorladetransistors (12).

11. Schaltung nach einem der Ansprüche 9 bis 10,
dadurch gekennzeichnet, daß
der Oszillator (7) das Oszillatorsteuersignal (ENOSC) empfängt, das vom Ausgang eines NOR-Gatters (19) mit zwei Eingängen geliefert wird, dessen Eingänge das Initialisierungssignal (ENABLE) und das Ausgangsvorladeinitialisierungssignal (INIT) empfangen, wobei der Oszillator (7) das Taktsignal (CLK) liefert, wenn dieses Steuersignal (ENOSC) aktiv ist.

12. Schaltung nach einem der Ansprüche 1 bis 11,
dadurch gekennzeichnet, daß
die Vorladetransistoren (10, 12, 33) N-Transistoren sind.

13. Schaltung nach einem der Ansprüche 1 bis 12,
dadurch gekennzeichnet, daß
das binäre Vorladesignal (SETUP), wenn es aktiv ist, ein höheres Potential hat als das Potential des ersten Eingangsanschlusses (2).

14. Schaltung nach einem der Ansprüche 1 bis 13,
dadurch gekennzeichnet, daß
sie als Diode (21, 48) parallel zu den Vorladetransistoren (10, 31) geschaltete Transistoren umfaßt.

15. Elektrisch programmierbarer Speicher,
dadurch gekennzeichnet, daß
er eine Spannungsvervielfacherschaltung nach einem der Ansprüche 1 bis 14 umfaßt.

## Claims

1. Voltage multiplier circuit (1) comprising at least one first input terminal (2) for receiving an input power supply voltage (VCC), an output terminal (5) for supplying a multiplied output power supply voltage (VBST), an oscillator (7) supplying a clock signal (CLK) on an output (8), a first capacitor (9), a first terminal of which is connected to the output of the oscillator (7), a first precharge transistor (10) mounted in series between the second terminal of the capacitor and the first input terminal in order to connect them when a binary precharge signal is active (SETUP), and an isolation transistor (11) mounted in series between the second terminal of the first capacitor (9) and the output terminal (5) in order to connect them when a binary discharge signal (GBST) is active, and a discharge control circuit (26 and 27) which supplies the binary discharge signal (GBST) so that, when the binary discharge signal (GBST) is active, it is at a potential greater than the sum of the potential of the first input terminal (2) and the highest potential of the clock signal (CLK), characterised in that the discharge control circuit (26 and 27) has a first and a second discharge circuit (26, 27), of the same type, mounted in series, each discharge circuit (26, 27) producing an output signal (H3), the maximum value of which is greater than the maximum value of an input signal (H1), by pumping, the first discharge circuit (26) receiving the clock signal (CLK) as an input signal (H1), the second discharge circuit (27) receiving as an input signal (H1) the output signal (H3) from the first discharge circuit (26), and the output signal (H3) from the second discharge circuit (27) being the binary discharge signal (GBST).

2. Circuit according to Claim 1, characterised in that it has precharge control means (13 to 15) for producing the precharge signal (SETUP) so that this precharge signal (SETUP) is active when the clock signal (CLK) is inactive and is inactive when the clock signal (CLK) is active.

3. Circuit according to Claim 2, characterised in that:
- it has a second input terminal (4) for receiving a binary initialisation signal (ENABLE),
- the precharge control means (13 to 15) have a two-input NOR gate (13) and a second capacitor (14),
- the NOR gate (13) receives the clock signal (CLK) on its first input and the initialisation signal (ENABLE) on its other input,
- the output of the NOR gate (13) is connected to a first terminal of the second capacitor (14),
- a second terminal of this capacitor (14) is connected, on the one hand, to the cathode of a diode (15), the anode of which is connected to the first input terminal (2), and, on the other hand, to the control gate of the first precharge transistor (10).

4. Circuit according to one of Claims 1 to 3, characterised in that the discharge control circuit (26 and 27) produces the discharge signal (GBST) so that the discharge signal (GBST) is active when the clock signal (CLK) is active and is inactive when the clock signal (CLK) is inactive.

5. Circuit according to one of Claims 1 to 4, characterised in that the first and second discharge circuits (26, 27) each have:
- a first input (28) for receiving the input signal (H1),
- a second input (29) for receiving an input clock signal (H2),
- a first output (30) for supplying the output signal (H3),
- a second output (31) for supplying an output clock signal (H4),
and in that:
- from the input signal (H1), the discharge circuit (26 or 27) produces a pumped internal power supply voltage (BST),
- the output clock signal (H4) is inactive when the input clock signal (H2) is inactive and it changes to the active state with a certain delay after the input clock signal (H2) changes to the active state,
- the output signal (H3) is at the potential of the pumped internal power supply voltage (BST) when the output clock signal (H4) is active, and at a reference potential (GND) supplied by a third input terminal (3) if the output clock signal (H4) is inactive.

6. Circuit according to Claim 5, characterised in that each discharge circuit (26 or 27) comprises:
- a third capacitor (32), one terminal of which is connected to the first input (28) of the discharge circuit (26 or 27), and the other terminal of which is connected to the first input terminal (2) by means of a second precharge field effect transistor (33), the control gate of which receives the precharge control signal (SETUP),
- a switch (34) comprising an input (35) for receiving the output clock signal (H4), and an output (39) for selectively connecting the first output (30) of the discharge circuit (26 or 27) to the second terminal of the third capacitor (32) or to the third input terminal (3).

7. Circuit according to one of Claims 5 to 6, characterised in that the first and second discharge circuits (26, 27) are mounted in series so that
- the first discharge circuit (26) receives the clock signal (CLK) on its two inputs (28, 29),
- the first input (28) of the second discharge circuit (27) is connected to the first output (30) of the first discharge circuit (26),
- the second input (29) of the second discharge circuit (27) is connected to the second output (31) of the first discharge circuit (26),
and in that the first output (30) of the second discharge circuit (27) is connected to the control gate of the isolation transistor (11).

8. Circuit according to one of Claims 1 to 7, characterised in that it has an output precharge transistor (12) for connecting the output terminal (5) to the first input terminal (2) when an output precharge initialisation signal (INIT) is active.

9. Circuit according to Claim 8, characterised in that it has output precharge control means (16 to 18) for producing the output precharge initialisation signal (INIT) so that:
- the latter changes from the inactive state to the active state when the initialisation signal (ENABLE) changes from the inactive state to the active state,
- this output precharge signal (INIT) changes to the inactive state after a certain delay,
- an oscillator control signal (ENOSC) is inactive while the initialisation signal (ENABLE) is inactive or while the output precharge signal (INIT) is active.

10. Circuit according to Claim 9, characterised in that the output precharge control means (16 to 18) comprise a monostable circuit (17) comprising an input (16) connected to the second input terminal (4) and an output (18) connected to the first terminal of a fourth capacitor (22), the second terminal of this capacitor (22) being connected to
- the first input terminal (2) by means of a third precharge transistor (23) receiving the initialisation signal (ENABLE) on its control terminal,
- the third input terminal (3) by means of a transistor (25), the control gate of which is connected to the output of a two-input NOR gate (24) receiving on its inputs the initialisation signal (ENABLE) and the output precharge initialisation signal (INIT),
- and the control gate of the output precharge transistor (12).

11. Circuit according to one of Claims 9 to 10, characterised in that the oscillator (7) receives the oscillator control signal (ENOSC) supplied by the output of a two-input NOR gate (19), the inputs of which receive the initialisation signal (ENABLE) and the output precharge initialisation signal (INIT), the oscillator (7) supplying the clock signal (CLK) when this control signal (ENOSC) is active.

12. Circuit according to one of Claims 1 to 11, characterised in that the precharge transistors (10, 12, 33) are n-type transistors.

13. Circuit according to one of Claims 1 to 12, characterised in that the binary precharge signal (SETUP), when active, is at a potential greater than the potential of the first input terminal (2).

14. Circuit according to one of Claims 1 to 13, characterised in that it has transistors mounted as diodes (21, 48), connected in parallel with the precharge transistors (10, 33).

15. Electrically programmable memory, characterised in that it includes a voltage multiplier circuit (1) defined according to one of Claims 1 to 14.
